# EUROPEAN PATENT APPLICATION

(11) **EP 3 536 747 A1**
(43) Date of publication of application: **11.09.2019**
(21) Application number: 17866632.7
(22) Date of filing: 23.10.2017
(51) Int. Cl.: C08L 83/07, C08L 83/05

(54) **REACTIVE HOT-MELT SILICONE FILLING CONTAINER AND METHOD FOR MANUFACTURING REACTIVE HOT-MELT SILICONE**

(30) Priority: 02.11.2016 JP 2016214766
(71) Applicant: Dow Toray Co., Ltd., Tokyo (JP)
(72) Inventor: YAMAZAKI, Haruna, Ichihara-shi Chiba 299-0108 (JP); SHIMA, Ryoto, Ichihara-shi Chiba 299-0108 (JP)
(74) Representative: Murgitroyd & Company
(86) International application number: PCT/JP2017/038184
(87) International publication number: WO 2018/084012

(57) **Abstract**

The reactive hot-melt silicone filling container of the present invention includes a crosslinkable silicone composition, the composition comprising: (A) an alkenyl group-bonded organopolysiloxane including at least a branched organopolysiloxane having an alkenyl group and a softening point of 50°C or higher; (B) an organopolysiloxane having at least two silicon atom-bonded hydrogen atoms per molecule; and (C) a hydrosilylation reaction catalyst, wherein the composition is filled into a container and the container is heated so as to crosslink the composition in the B-stage state, to form reactive hot-melt silicone that is non-fluid at 25°C and has a melt viscosity of 5,000 Pa·s or lower at 120°C. The reactive hot-melt silicone filling container can extract reactive hot-melt silicone having excellent gap filling properties upon heating.

## Description

### TECHNICAL FIELD

The present invention relates to a reactive hot-melt silicone filling container, along with a method for manufacturing the reactive hot-melt silicone.

### BACKGROUND ART

Upon manufacturing a chip array module with a large number of LED elements disposed on a substrate, a sheet shaped reactive hot-melt silicone is used in order to collectively seal or coat a large number of LED elements. For example, Patent Document 1 proposes a reactive hot-melt silicone obtained by half-curing, into a sheet shape, a crosslinkable silicone composition comprising: an organopolysiloxane having at least two alkenyl silyl groups per molecule, an organopolysiloxane having at least two hydrosilyl groups per molecule, a hydrosilylation reaction catalyst, and a reaction inhibitor.

Unfortunately, this sheet shaped reactive hot-melt silicone, due to a gap between an LED element and a substrate, easily entrains air upon sealing or coating, resulting in problems such as poor appearance of sealed or coated LEDs, as well as reduced reliability.

Moreover, upon preparing reactive hot-melt silicone, heating of a crosslinkable silicone composition problematically causes the vaporization of components, as well as air inhibition of the hydrosilylation reaction.

### PRIOR ART DOCUMENTS

### PATENT DOCUMENTS

Patent Document 1: Japanese Unexamined Patent Application Publication No. 2011-219597 A

### SUMMARY OF THE INVENTION

### PROBLEMS TO BE SOLVED BY THE INVENTION

An object of the present invention is to provide a reactive hot-melt silicone filling container that can extract reactive hot-melt silicone having excellent gap filling properties upon heating, as well as a method for manufacturing reactive hot-melt silicone that suppresses the vaporization of components and air inhibition during heating, is fluid upon heating, and has excellent gap filling properties.

### MEANS FOR SOLVING THE PROBLEMS

The reactive hot-melt silicone filling container of the present invention includes a crosslinkable silicone composition, the composition comprising:
(A) an alkenyl group-bonded organopolysiloxane including at least a branched organopolysiloxane having an alkenyl group and a softening point of 50°C or higher;
(B) an organopolysiloxane having at least two silicon atom-bonded hydrogen atoms per molecule, in an amount such that the silicon atom-bonded hydrogen atoms in this component are 0.01 to 10 moles with regard to 1 mole of the alkenyl groups in component (A); and
(C) a hydrosilylation reaction catalyst in a catalyst amount,
wherein the composition is filled into a container and the container is heated so as to crosslink the composition in the B-stage state, to form reactive hot-melt silicone that is non-fluid at 25°C, and has a melt viscosity of 5,000 Pa·s or lower at 120°C.

The crosslinkable silicone composition preferably further comprises (D) 0.0001 to 5 parts by mass of a reaction inhibitor and/or (E) 0.01 to 10 parts by mass of an organic peroxide, with regard to 100 parts by mass of the total of components (A) to (C).

Moreover, the container is preferably a cartridge, a flexible container, a pail can, or a drum.

The method for manufacturing reactive hot-melt silicone of the present invention, the silicone being non-fluid at 25°C, having a melt viscosity of 5,000 Pa·s or lower at 120°C, and comprising:
heating a crosslinkable silicone composition in a container, the composition comprising:
(A) an alkenyl group-bonded organopolysiloxane including at least a branched organopolysiloxane having an alkenyl group and a softening point of 50°C or higher;
(B) an organopolysiloxane having at least two silicon atom-bonded hydrogen atoms per molecule, in an amount such that the silicon atom-bonded hydrogen atoms in this component are 0.01 to 10 moles with regard to 1 mole of the alkenyl groups in component (A); and
(C) a hydrosilylation reaction catalyst in a catalyst amount,
so as to crosslink the composition in the B-stage state.

The crosslinkable silicone composition preferably further comprises (D) 0.0001 to 5 parts by mass of a reaction inhibitor and/or (E) 0.01 to 10 parts by mass of an organic peroxide, with regard to 100 parts by mass of the total of components (A) to (C).

Moreover, the container is preferably a cartridge, a flexible container, a pail can, or a drum.

### EFFECTS OF THE INVENTION

The reactive hot-melt silicone filling container according to the present invention can extract reactive hot-melt silicone having excellent gap filling properties upon heating, and the method for manufacturing reactive hot-melt silicone according to the present invention can manufacture reactive hot-melt silicone that suppresses the vaporization of components and air inhibition during heating, is fluid upon heating, and has excellent gap filling properties.

### BRIEF DESCRIPTION OF THE DRAWINGS

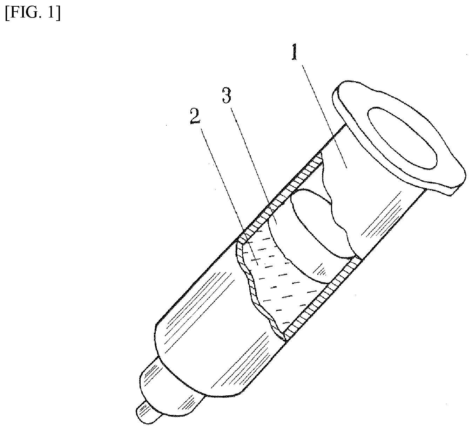

FIG. 1 is a perspective view having a partial fracture surface illustrating a cartridge, which is one example of a reactive hot-melt silicone filling container according to the present invention.

### MODE FOR CARRYING OUT THE INVENTION

First, the reactive hot-melt silicone filling container of the present invention will be described in detail.

The reactive hot-melt silicone filling container of the present invention includes a crosslinkable silicone composition, the composition comprising:
(A) an alkenyl group-bonded organopolysiloxane including at least a branched organopolysiloxane having an alkenyl group and a softening point of 50°C or higher;
(B) an organopolysiloxane having at least two silicon atom-bonded hydrogen atoms per molecule, in an amount such that the silicon atom-bonded hydrogen atoms in this component are 0.01 to 10 moles with regard to 1 mole of the alkenyl groups in component (A); and
(C) a hydrosilylation reaction catalyst in a catalyst amount,
wherein the composition is filled into a container, and the container is heated so as to crosslink the composition in the B-stage state. Note that this "B-stage state" refers to the state of the B-stage (a cured intermediate product of thermosetting resin) defined in JIS K 6800, wherein, when a crosslinkable silicone composition is incompletely cured, it swells due to a solvent, but is not completely dissolved, while "reactive hot-melt" refers to the state in which fluidity is lost at room temperature (25°C), but when a composition is heated to a high temperature (for example, 120°C or higher), it is melted again, then cured.

Component (A) is an alkenyl group-bonded organopolysiloxane including at least a branched organopolysiloxane having an alkenyl group and a softening point of 50°C or higher. The branched organopolysiloxane having a softening point is an organopolysiloxane that has, in a molecular chain, a siloxane unit represented by the formula: R¹SiO_{3/2} and/or a siloxane unit represented by the formula: SiO_{4/2}, and further may have a siloxane unit represented by the formula: R¹₃SiO_{1/2} and/or a siloxane unit represented by the formula: R¹₂SiO_{2/2}. In the formula, R¹ represents the same or different monovalent hydrocarbon groups, with examples thereof including: alkyl groups with 1 to 12 carbon atoms such as a methyl group, an ethyl group, a propyl group, a butyl group, a pentyl group, a hexyl group, a cyclopentyl group, and a cyclohexyl group; alkenyl groups with 2 to 12 carbon atoms such as a vinyl group, an allyl group, a butenyl group, a pentenyl group, and a hexenyl group; aryl groups with 6 to 12 carbon atoms such as a phenyl group, a tolyl group, and a xylyl group; aralkyl groups with 7 to 12 carbon atoms such as a benzyl group and a phenethyl group; and groups obtained by substituting all or part of the hydrogen atoms of these groups with halogen atoms such as a chlorine atom and a fluorine atom. Note that at least one R¹ per molecule is an alkenyl group.

The softening point of such a branched organopolysiloxane is 50°C or higher. This softening point refers to, for example, temperatures measured by the softening point testing method in the ball and ring method of hot melt adhesives specified in "Testing methods for the softening point of hot melt adhesives" of JIS K 6863-1994. Exemplary organopolysiloxanes having such a softening point include: an organopolysiloxane comprising a siloxane unit represented by the formula: R¹SiO_{3/2}, wherein 50 to 80 mole% of all R¹ per molecule are aryl groups; an organopolysiloxane comprising a siloxane unit represented by the formula: R¹SiO_{3/2} and a siloxane unit represented by the formula: R¹₃SiO_{1/2}, wherein 50 to 80 mole% of all R¹ per molecule are aryl groups; an organopolysiloxane comprising a siloxane unit represented by the formula: R¹SiO_{3/2} and a siloxane unit represented by the formula: R¹₂SiO_{2/2}, wherein 50 to 80 mole% of all R¹ per molecule are aryl groups; an organopolysiloxane comprising a siloxane unit represented by the formula: R¹SiO_{3/2}, a siloxane unit represented by the formula: R¹₂SiO_{2/2}, and a siloxane unit represented by the formula: R¹₃SiO_{1/2}, wherein 50 to 80 mole% of all R¹ per molecule are aryl groups; an organopolysiloxane comprising a siloxane unit represented by the formula: SiO_{4/2} and a siloxane unit represented by the formula: R¹₃SiO_{1/2}; and an organopolysiloxane comprising a siloxane unit represented by the formula: SiO_{4/2}, a siloxane unit represented by the formula: R¹₃SiO_{1/2}, and a siloxane unit represented by the formula: R¹₂SiO_{2/2}.

Component (A) may only be the abovementioned branched organopolysiloxane, and may be a mixture of the abovementioned branched organopolysiloxane and a linear organopolysiloxane. This linear organopolysiloxane is a component for adjusting the hardness of the cured product obtained by curing reactive hot-melt silicone, and for imparting the flexibility thereof, and is represented by the general formula:

R²₃SiO(R²₂SiO)ₙSiR²₃.

In the formula, R² represents the same or different monovalent hydrocarbon groups, with examples thereof including the same groups as in R¹. Note that at least two R² per molecule are the alkenyl groups. Moreover, in the formula, "n" is preferably an integer within the range of 1 to 1,000, alternatively an integer within the range of 1 to 500, alternatively an integer within the range of 5 to 500, and alternatively an integer within the range of 10 to 500. This is because, when "n" is not less than the lower limit of the abovementioned range, the mechanical strength of the obtained cured product is favorable; on the other hand, when "n" is not more than the upper limit of the abovementioned range, the filling performance of the obtained crosslinkable silicone composition is favorable.

While the ratio of the branched organopolysiloxane and the linear organopolysiloxane in component (A) is not limited, the linear organopolysiloxane in component (A) is preferably of an amount within the range of 0 to 80 mass%, alternatively an amount within the range of 0 to 70 mass%, alternatively an amount within the range of 0 to 60 mass%, alternatively an amount within the range of 5 to 80 mass%, alternatively an amount within the range of 5 to 70 mass%, alternatively an amount within the range of 5 to 60 mass%, alternatively an amount within the range of 10 to 80 mass%, alternatively an amount within the range of 10 to 70 mass%, and alternatively an amount within the range of 10 to 60 mass%. This is because, when the content of the linear organopolysiloxane is not less than the lower limit of the abovementioned range, the mechanical properties of the obtained cured product are favorable; on the other hand, when the content is not more than the upper limit of the abovementioned range, the hot-melt properties of the obtained reactive hot melt silicone are favorable.

Component (B) is an organopolysiloxane having at least two silicon atom-bonded hydrogen atoms per molecule. Examples of the silicon atom-bonded organic group in component (B) include: alkyl groups with 1 to 12 carbon atoms such as a methyl group, an ethyl group, a propyl group, a butyl group, a pentyl group, a hexyl group, a cyclopentyl group, and a cyclohexyl group; aryl groups with 6 to 12 carbon atoms such as a phenyl group, a tolyl group, and a xylyl group; aralkyl group with 7 to 12 carbon atoms such as a benzyl group and a phenethyl group; along with groups obtained by substituting all or part of the hydrogen atoms of these groups with halogen atoms such as chlorine atoms and fluorine atoms. While the molecular structure of component (B) is not limited, examples thereof include a linear structure, a partially branched linear structure, a cyclic structure, and a branched structure.

Examples of such a component (B) include: a dimethylpolysiloxane capped at both molecular chain terminals with dimethylhydrogensiloxy groups; a diphenylsiloxane oligomer capped at both molecular chain terminals with dimethylhydrogensiloxy groups; a methylphenylpolysiloxane capped at both molecular chain terminals with dimethylhydrogensiloxy groups; a methylphenylsiloxane oligomer capped at both molecular chain terminals with dimethylhydrogensiloxy groups; a copolymer of dimethylsiloxane and methylhydrogensiloxane capped at both molecular chain terminals with dimethylhydrogensiloxy groups; a methylhydrogenpolysiloxane capped at both molecular chain terminals with trimethylsiloxy groups; a copolymer of dimethylsiloxane and methylhydrogensiloxane capped at both molecular chain terminals with trimethylsiloxy groups; an organopolysiloxane consisting of a siloxane unit represented by the formula: SiO_{4/2} and a siloxane unit represented by the formula: (CH₃)₂HSiO_{1/2}; an organopolysiloxane consisting of a siloxane unit represented by the formula: SiO_{4/2}, a siloxane unit represented by the formula: (CH₃)₂HSiO_{1/2}, and a siloxane unit represented by the formula: (CH₃)₃SiO_{1/2}; an organopolysiloxane consisting of a siloxane unit represented by the formula: HMe₂SiO_{1/2} and a siloxane represented by the formula: C₆H₅SiO_{3/2}; and mixtures of two or more thereof.

The content of component (B) is in an amount such that the silicon atom-bonded hydrogen atoms in this component are within the range of 0.01 to 10 moles, preferably within the range of 0.01 to 5 moles, alternatively within the range of 0.05 to 5 moles, and alternatively within the range of 0.01 to 5 moles, with regard to a total of 1 mole of the alkenyl groups in component (A). This is because, when the content of component (B) is not less than the lower limit of the abovementioned range, the hydrosilylation reaction of this composition sufficiently progresses, allowing the B-stage state reactive hot-melt silicone to be obtained; on the other hand, when the content is not more than the upper limit of the abovementioned range, the heat resistance of the cured product obtained by curing reactive hot-melt silicone is favorable. Note that for the case in which the below-mentioned organic peroxide is blended in this composition, in order to crosslink this composition in the B-stage state, the silicon atom-bonded hydrogen atoms in component (B) may be of an amount of 1 mole or lower, or an amount lower than 1 mole, with regard to 1 mole of the alkenyl groups in component (A). This is because, even when all the silicon atom-bonded hydrogen atoms in component (B) are reacted to crosslink this composition, the obtained reactive hot-melt silicone can be thermosetted by an organic peroxide.

Component (C) is a catalyst for promoting the hydrosilylation reaction of the alkenyl groups in component (A) with the silicon atom-bonded hydrogen atoms in component (B), with examples thereof including a platinum based catalyst, a rhodium based catalyst, and a palladium based catalyst. A platinum based catalyst is particularly preferable because it can significantly promote the hydrosilylation reaction of this composition. Examples of this platinum based catalyst include platinum fine powder, chloroplatinic acid, an alcohol solution of chloroplatinic acid, a platinum-alkenyl siloxane complex, a platinum-olefin complex, and a platinum-carbonyl complex, with a platinum-alkenyl siloxane complex particularly preferable. Examples of this alkenyl siloxane include: 1,3-divinyl-1,1,3,3-tetramethyldisiloxane; 1,3,5,7-tetramethyl-1,3,5,7-tetravinylcyclotetrasiloxane; an alkenyl siloxane obtained by substituting part of methyl groups of these alkenyl siloxanes with an ethyl group, a phenyl group, etc.; and an alkenyl siloxane obtained by substituting part of vinyl groups of these alkenyl siloxanes with an allyl group, a hexenyl group, etc.

The content of component (C) is the catalyst amount that promotes the hydrosilylation reaction of this composition, and is preferably an amount in which the metal atoms in this component are, in mass units, within the range of 0.01 to 1,000 ppm, alternatively within the range of 0.01 to 500 ppm, alternatively within the range of 0.01 to 200 ppm, alternatively within the range of 0.01 to 100 ppm, and alternatively within the range of 0.01 to 50 ppm, with regard to the total amount of component (A) and component (B). This is because when the content of component (C) is not less than the lower limit of the abovementioned range, the hydrosilylation reaction of this composition is promoted; on the other hand, when the amount is not more than the upper limit of the abovementioned range, problems such as coloring of the obtained reactive hot melt silicone are less likely to occur.

This composition may comprise (D) a reaction inhibitor in order to control the hydrosilylation reaction of this composition. Examples of component (D) include: alkyne alcohols such as 1-ethynylcyclohexan-1-ol, 2-methyl-3-butyn-2-ol, 3,5-dimethyl-1-hexyn-3-ol, and 2-phenyl-3-butyn-2-ol; enyne compounds such as 3-methyl-3-penten-1-yne and 3,5-dimethyl-3-hexen-1-yne; alkynoxysilanes such as tris(1,1-dimethylpropynoxy)methylsilane and bis(1,1-dimethylpropynoxy)dimethylsilane; alkenyl group-containing cyclosiloxanes not corresponding to component (A) such as 1,3,5,7-tetramethyl-1,3,5,7-tetravinyl cyclotetrasiloxane, and 1,3,5,7-tetramethyl-1,3,5,7-tetrahexenyl cyclotetrasiloxane; and benzotriazole.

While not limited thereto, the content of component (D) is preferably within the range of 0 to 5 parts by mass, alternatively within the range of 0.0001 to 5 parts by mass, with regard to 100 parts by mass of the total of the abovementioned components (A) to (C). This is because while component (D) may be optionally blended, when the content of component (D) is within the abovementioned range, reactive hot-melt silicone is easily prepared.

In order to thermoset the obtained reactive hot-melt silicone, (E) an organic peroxide may be further blended in this composition as required. Component (E) preferably has no activity upon crosslinking this composition in the B-stage state but has activity upon heating the obtained reactive hot-melt silicone, and preferably has a 10 hour half-life temperature of 90°C or higher, for example. Examples of component (E) include alkyl peroxides, diacyl peroxides, ester peroxides, and carbonate peroxides.

Examples of alkyl peroxides include dicumyl peroxide, di-tert-butyl peroxide, di-tert-butylcumyl peroxide, 2,5-dimethyl-2,5-di(tert-butylperoxy)hexane, 2,5-dimethyl-2,5-di(tert-butylperoxy)hexyne-3, tert-butylcumyl, 1,3-bis(tert-butylperoxyisopropyl)benzene, and 3,6,9-triethyl-3,6,9-trimethyl-1,4,7-triperoxonan.

Examples of diacyl peroxides include benzoyl peroxide, lauroyl peroxide, and decanoyl peroxide.

Examples of ester peroxides include 1,1,3,3-tetramethylbutylperoxyneodecanoate, α-cumylperoxyneodecanoate, tert-butylperoxyneodecanoate, tert-butylperoxyneoheptanoate, tert-butylperoxypivalate, tert-hexylperoxypivalate, 1,1,3,3-tetramethylbutylperoxy-2-ethylhexanoate, tert-amylperoxyl-2-ethylhexanoate, tert-butylperoxy-2-ethylhexanoate, tert-butylperoxyisobutyrate, di-tert-butylperoxyhexahydroterephthalate, tert-amylperoxy-3,5,5-trimethylhexanoate, tert-butylperoxy-3,5,5-trimethylhexanoate, tert-butylperoxyacetate, tert-butylperoxybenzoate, and di-butylperoxytrimethyladipate.

Examples of carbonate peroxides include di-3-methoxybutyl peroxydicarbonate, di(2-ethylhexyl)peroxydicarbonate, diisopropyl peroxycarbonate, tert-butyl peroxyisopropylcarbonate, di(4-tert-butylcyclohexyl)peroxydicarbonate, dicetyl peroxydicarbonate, and dimyristyl peroxydicarbonate.

Component (E) is preferably an alkyl peroxide and particularly preferably has a 10 hour half-life temperature of 90°C or higher, alternatively 95°C or higher. Examples of such component (E) include dicumyl peroxide, di-t-butyl peroxide, di-t-hexyl peroxide, t-butylcumyl peroxide, 2,5-dimethyl-2,5-di(tert-butylperoxy)hexane, 1,3-bis(tert-butylperoxyisopropyl)benzene, di-(2-t-butylperoxyisopropyl)benzene, and 3,6,9-triethyl-3,6,9-trimethyl-1,4,7-triperoxonan.

While not limited thereto, the content of component (E) is preferably within the range of 0.01 to 10 parts by mass, alternatively within the range of 0.05 to 10 parts by mass, alternatively within the range of 0.05 to 5 parts by mass, and alternatively within the range of 0.01 to 5 parts by mass, with regard to 100 parts by mass of the total of components (A) to (C). This is because, when the content of component (E) is not less than the lower limit of the abovementioned range, the obtained reactive hot-melt silicone can be sufficiently thermosetted; on the other hand, when the content is not more than the upper limit of the abovementioned range, air bubbles, etc. are less likely to occur in the obtained cured product.

Moreover, in order to impart adhesion to the obtained reactive hot-melt silicone, an adhesion imparting agent may be blended in this composition. An organosilicon compound having at least one silicon atom-bonded alkoxy group per molecule is preferable as this adhesion imparting agent. Examples of this alkoxy group include a methoxy group, an ethoxy group, a propoxy group, a butoxy group, and a methoxyethoxy group, with a methoxy group particularly preferable. Moreover, examples of silicon atom-bonded groups other than this alkoxy group in the organosilicon compound include: halogen substituted or unsubstituted monovalent hydrocarbon groups such as an alkyl group, an alkenyl group, an aryl group, an aralkyl group, and a halogenated alkyl group; glycidoxyalkyl groups such as a 3-glycidoxypropyl group and a 4-glycidoxybutyl group; epoxycyclohexylalkyl groups such as a 2-(3,4-epoxycyclohexyl)ethyl group and a 3-(3,4-epoxycyclohexyl)propyl group; epoxyalkyl groups such as a 3,4-epoxybutyl group and a 7,8-epoxyoctyl group; acryl group-containing monovalent organic groups such as a 3-methacryloxypropyl group; and hydrogen atoms. This organosilicon compound preferably has a group that may react with an alkenyl group or a silicon atom-bonded hydrogen atom in this composition, and specifically, preferably has a silicon atom-bonded hydrogen atom or an alkenyl group. Moreover, because favorable adhesion can be imparted to various base materials, this organosilicon compound preferably has at least one epoxy group-containing a monovalent organic group per molecule. Examples of such an organosilicon compound include an organosilane compound, an organosiloxane oligomer, and an alkyl silicate. Examples of the molecular structure of this organosiloxane oligomer or alkyl silicate include a linear structure, a partially branched linear structure, a branched structure, a cyclic structure, and a network structure, with a linear structure, a branched structure, and a network structure particularly preferable. Examples of such an organosilicon compound include: silane compounds such as 3-glycidoxypropyl trimethoxysilane, 2-(3,4-epoxycyclohexyl)ethyl trimethoxysilane, and 3-methacryloxypropyl trimethoxysilane; siloxane compounds having at least one of silicon atom-bonded alkenyl group or silicon atom-bonded hydrogen atom, and at least one silicon atom-bonded alkoxy group per molecule; and mixtures of a silane compound or siloxane compound having at least one silicon atom-bonded alkoxy group and a siloxane compound having at least one silicon atom-bonded hydroxyl group and at least one silicon atom-bonded alkenyl group per molecule; methylpolysilicate; ethylpolysilicate; and an epoxy group-containing ethylpolysilicate. Note that while not limited thereto, the content of this adhesion imparting agent is preferably within the range of 0.01 to 10 parts by mass with regard to 100 parts by mass of the total of components (A) to (C). This is because, when the content of the adhesion imparting agent is within the abovementioned range, the adhesion of the obtained reactive hot-melt silicone is favorable.

Moreover, as other components, an organopolysiloxane not having an alkenyl group and a silicon atom-bonded hydrogen atom, such as a trimethylsiloxy-blocked dimethylpolysiloxane, a trimethylsiloxy-blocked copolymer of dimethylsiloxane and methylphenylsiloxane, and an organopolysiloxane consisting of a siloxane unit represented by the formula: (CH₃)₃SiO_{1/2} and a siloxane unit represented by the formula: SiO_{4/2}, etc. may be blended in this composition as long as it does not impair the object of the present invention. The softening point of this organopolysiloxane is preferably 50°C or higher. While not limited thereto, the blending amount of such an organopolysiloxane is preferably within the range of 0 to 250 parts by mass with regard to 100 parts by mass of the total of components (A) to (C). This is because, when the content of such an organopolysiloxane is within the abovementioned range, reactive hot-melt silicone is easily prepared.

Further, as other components, an inorganic filler such as silica, titanium oxide, glass, alumina, and zinc oxide; an organic resin fine powder such as polymethacrylate resin; a heat resistant agent; a phosphor; a dye; a pigment; and a fire retardant imparting agent may be blended in this composition.

A crosslinkable silicone composition comprising the abovementioned components (A) to (C) and further comprising other components as required is filled into a container and the container is heated. Upon filling this composition into the container, this composition is preferably deaerated. After filling, the container with this composition filled therein is heated so as to crosslink this composition in the B-stage state.

The thus obtained reactive hot-melt silicone is non-fluid at 25°C, and has a melt viscosity of 5,000 Pa·s or lower at 120°C, preferably within the range of 10 to 3,500 Pa·s. Here, non-fluid refers to not flowing in the unloaded state, for example, the state of being lower than the softening point measured by the softening point testing method in the ball and ring method of hot melt adhesives specified in "Testing methods for the softening point of hot melt adhesives" of JIS K 6863-1994. That is, in order to be non-fluid at 25°C, the softening point must be higher than 25°C. This is because, when non-fluid at 25°C, reactive hot-melt silicone having favorable shape retainability at this temperature and having low surface tack is obtained. Moreover, when the melt viscosity at 120°C is within the abovementioned range, reactive hot-melt silicone having favorable adhesiveness after being hot-melted and then cooled at 25°C is obtained.

The container that can be used in the reactive hot-melt silicone filling container of the present invention is not particularly limited as long as it has heat resistance and does not inhibit the hydrosilylation reaction of the crosslinkable silicone composition. Examples of such a container include a plastic or metal cartridge; a flexible container such as a plastic film pack, a metal foil laminated film pack, a bellows shaped container, and a tubular container; a plastic or metal pail can; and a plastic or metal drum, with a cartridge particularly preferable. Such a cartridge is available, for example, from PSY-30FH2-P and PSY-30FH-P produced by Musashi Engineering, Inc.

A perspective view having a partial fracture surface of a cartridge, which is one example of the reactive hot-melt silicone filling container of the present invention is illustrated in FIG. 1. In FIG. 1, reactive hot-melt silicone 2 is filled into cartridge 1, with plunger 3 for melting and extruding the reactive hot-melt silicone provided inside the cartridge. Generally, a cartridge is attached to a melter so as to render reactive hot-melt silicone into a molten state, and the plunger is moved by mechanical force or gas pressure so as to extrude the reactive hot-melt silicone. Note that by controlling the discharge amount of the reactive hot-melt silicone, the shape, film thickness, application area, etc. can be controlled.

In accordance with the reactive hot-melt silicone filling container of the present invention, an optical semiconductor element mounted on a substrate having a flat surface can be sealed or coated in any shape such as a hemispherical shape, a semicircular shape, or a dome shape with no air entrainment.

Next, the method for manufacturing reactive hot-melt silicone of the present invention will be described in detail.

The method for manufacturing reactive hot-melt silicone of the present invention is as described above, wherein a crosslinkable silicone composition comprising the abovementioned components (A) to (C), and further comprising other components as required is heated in a container and crosslinked in the B-stage state.

In the manufacturing method of the present invention, because this composition is heated in a container and crosslinked in the B-stage state, vaporization of the low molecular weight components, reaction inhibition, etc. contained in this composition is suppressed, and problems such as air inhibition, involved in the hydrosilylation reaction, tend not to occur.

### EXAMPLES

The reactive hot-melt silicone filling container and the method for manufacturing reactive hot-melt silicone of the present invention will be described in detail by way of examples. Note that in the formulae, Me, Ph, and Vi represent a methyl group, a phenyl group, and a vinyl group, respectively. Moreover, the melt viscosity of the reactive hot-melt silicone at 120°C, the time at which the initial torque value is exhibited, and the hardness of the cured product were measured as follows.

### <Melt Viscosity of Reactive Hot-melt Silicone>

The melt viscosity of reactive hot-melt silicone at 120°C was measured at a shear rate of 1/s by an AR550 Rheometer produced by TA Instruments using a cone plate with a diameter of 20 mm and a cone angle of 2°.

### <Time until Initial Torque Value is Exhibited>

6 g of reactive hot-melt silicone was set for a disk shaped die hollow part including a fixed lower die and an elevating upper die of a measuring apparatus (ALPHA TECHNOLOGIES Rheometer MDR 2000P) set to a predetermined temperature, the upper and lower dies were closed, and the time until the torque value reached 1 dNm was measured under conditions of a vibration frequency number of 1.66 Hz and a vibration angle of 1° and defined as "the time until the initial torque value is exhibited."

### <Hardness of Cured Product>

The reactive hot-melt silicone was pressed and molded at 150°C for 2 hours to produce a sheet shaped cured product. The hardness of this sheet shaped cured product was measured by the type D durometer specified in JIS K 6253.

### <Examples 1 to 5>

A crosslinkable silicone composition was prepared by uniformly mixing the below-mentioned components in the composition (parts by mass) shown in Table 1. Note that in Table 1, SiH/Vi represents the number of moles of silicon atom-bonded hydrogen atoms in component (B) with regard to 1 mole of vinyl groups in component (A). Subsequently, this crosslinkable silicone composition was filled into a cartridge having a capacity of 30 cc, heated under the conditions shown in Table 1, and then cooled to room temperature to produce a reactive hot-melt silicone filling container.

The following components were used as component (A).
Component (a-1): a methylphenylpolysiloxane represented by the formula:

   ViMe₂SiO(MePhSiO)₈₀SiMe₂Vi
Component (a-2): a methylphenylpolysiloxane represented by the formula:

   ViMe₂SiO(MePhSiO)₁₈SiMe₂Vi
Component (a-3): an organopolysiloxane with a softening point of 100°C, represented by the average unit formula:

   (MeViSiO_{2/2})_{0.3}(PhSiO_{3/2})_{0.7}
Component (a-4): an organopolysiloxane with a softening point of 150°C, represented by the average unit formula:

   (MeViSiO_{2/2})_{0.10}(Me₂SiO_{2/2})_{0.15}(PhSiO_{3/2})_{0.75}

The following component was used as component (B).
Component (b-1): an organopolysiloxane represented by the formula:

Me₂HSiOPh₂SiOSiMe₂H

The following component was used as component (C).
Component (c-1): a 1,3,5,7-tetramethyl-1,3,5,7-tetravinylcyclotetrasiloxane solution (solution containing 0.1 wt% of a platinum metal) of a platinum-1,3-divinyl-1,1,3,3-tetramethyldisiloxane complex.

The following component was used as another component.
Component (f-1): an adhesion imparting agent containing a condensation reaction product of 3-glycidoxypropyl trimethoxysilane and methylvinylsiloxane oligomer endblocked at both molecular chain terminals with silanol groups and having a viscosity of 30 mPa·s.

**<Table 1>**

| | | Example | | | | |
|---|---|---|---|---|---|---|
| | | 1 | 2 | 3 | 4 | 5 |
| Composition of Crosslinkable Silicone Composition (parts by mass) | component (a-1) | - | - | - | - | 23.13 |
| | component (a-2) | - | 10.00 | 40.00 | 20.00 | 10.20 |
| | component (a-3) | 69.72 | 61.88 | 38.13 | 46.42 | 34.95 |
| | component (a-4) | - | - | - | 9.74 | 11.92 |
| | component (b-1) | 30.28 | 28.12 | 21.81 | 23.34 | 19.30 |
| | component (c-1) | 0.0025 | 0.0025 | 0.0025 | 0.0025 | 0.0025 |
| | component (f-1) | 0.50 | 0.50 | 0.50 | 0.50 | 0.50 |
| SiH/Vi | | 1.0 | 1.0 | 1.0 | 1.0 | 1.0 |
| Conditions (temperature/time) for Obtaining B-stage | | 120°C/20 minutes | 120°C/20 minutes | 120°C/50 minutes | 120°C/20 minutes | 120°C/20 minutes |
| Melt Viscosity (Pa·s) of Reactive Hot-melt Silicone at 120°C | | 29.3 | 37.2 | 210 | 20.6 | 87.5 |
| Time (minutes) until Initial Torque Value of Reactive Hot-melt Silicone is Exhibited at 150°C | | 4 | 4 | 10 | 6 | 7 |
| Hardness of Cured Product | | 75 | 72 | 38 | 58 | 50 |

### <Examples 6 to 9>

A crosslinkable silicone composition was prepared by uniformly mixing the abovementioned and below mentioned components in the composition (parts by mass) shown in Table 2. Note that in Table 2, SiH/Vi represents the number of moles of silicon atom-bonded hydrogen atoms in component (B) with regard to 1 mole of vinyl groups in component (A). Subsequently, this crosslinkable silicone composition was filled into a cartridge having a capacity of 30 cc, heated under the conditions shown in Table 2, then cooled to room temperature to produce a reactive hot-melt silicone filling container.

In addition to those mentioned above, the following components were used as component (A).
Component (a-5): an organopolysiloxane with a softening point of 300°C, represented by the average unit formula:

   (Me₂ViSiO_{1/2})_{0.10}(Me₃SiO_{1/2})_{0.40}(SiO_{4/2})_{0.50}
Component (a-6): an organopolysiloxane with a softening point of 300°C, represented by the average unit formula:

   (Me₂ViSiO_{1/2})_{0.04}(Me₃SiO_{1/2})_{0.40}(Sio_{4/2})_{0.56}
Component (a-7): a dimethylpolysiloxane represented by the formula:

   ViMe₂SiO(Me₂SiO)₇₇₀SiMe₂Vi
Component (a-8): an organopolysiloxane with a softening point of 100°C, represented by the average unit formula:

   (Me₂ViSiO_{1/2})_{0.25}(PhSiO_{3/2})_{0.75}

In addition to those mentioned above, the following component was used as component (B).
Component (b-2): an organopolysiloxane represented by the formula:

Me₂HSiO(Me₂SiO)₂₅SiMe₂H

The following components were used as component (D).
Component (d-1): 1,3,5,7-tetramethyl-1,3,5,7-tetravinyl cyclotetrasiloxane
Component (d-2): tris(1,1-dimethylpropynoxy)methylsilane

In addition to those mentioned above, the following component was used as component (E).
Component (e-1): 2,5-dimethyl-2,5-di(t-butylperoxy)hexane

The following component was used as another component.
Component (g-1): an organopolysiloxane with a softening point of 100°C, represented by the average unit formula:

(Me₃SiO_{1/2})_{0.44}(SiO_{4/2})_{0.56}

**<Table 2>**

| | | Example | | | |
|---|---|---|---|---|---|
| | | 6 | 7 | 8 | 9 |
| Composition of Crosslinkable Silicone Composition (parts by mass) | component (a-1) | - | - | 18.19 | 15.83 |
| | component (a-5) | 44.0 | 33.2 | - | - |
| | component (a-6) | - | 24.6 | - | - |
| | component (a-7) | 3.10 | 2.30 | - | - |
| | component (a-8) | - | - | 64.89 | 56.49 |
| | component (b-1) | - | - | 14.66 | 24.45 |
| | component (b-2) | 11.40 | 8.60 | - | - |
| | component (c-1) | 0.06 | 0.04 | 0.07 | 0.14 |
| | component (d-1) | - | - | 1.82 | 2.85 |
| | component (d-2) | - | - | - | 0.63 |
| | component (e-1) | 1.0 | 0.7 | 0.36 | 0.32 |
| | component (g-1) | 40.5 | 30.5 | - | - |
| SiH/Vi | | 0.3 | 0.2 | 0.5 | 0.9 |
| Conditions (temperature/time) for Obtaining B-stage | | 120°C/30 minutes | 120°C/30 minutes | 120°C/30 minutes | 120°C/30 minutes |
| Melt Viscosity (Pa·s) of Reactive Hot-melt Silicone at 120°C | | 250 | 2580 | 170 | 50 |
| Time (seconds) until Initial Torque Value of Reactive Hot-melt Silicone is Exhibited at 180°C | | 10 | 71 | 30 | 10 |
| Hardness of Cured Product | | 30 | 48 | 56 | 25 |

### INDUSTRIAL APPLICABILITY

Because the reactive hot-melt silicone filling container of the present invention can extract reactive hot-melt silicone having favorable gap filling properties upon heating, the optical semiconductor element in a chip array module on which an optical semiconductor element such as an LED is mounted on a substrate can be effectively sealed and coated.

### REFERENCE NUMERALS

- 1: Cartridge
- 2: Reactive hot-melt silicone
- 3: Plunger

## Claims

1. A reactive hot-melt silicone filling container including a crosslinkable silicone composition, the composition comprising:
(A) an alkenyl group-bonded organopolysiloxane including at least a branched organopolysiloxane having an alkenyl group and a softening point of 50°C or higher;
(B) an organopolysiloxane having at least two silicon atom-bonded hydrogen atoms per molecule, in an amount such that the silicon atom-bonded hydrogen atoms in this component are 0.01 to 10 moles with regard to 1 mole of the alkenyl groups in component (A); and
(C) a hydrosilylation reaction catalyst in a catalyst amount,
wherein the composition is filled into a container, and the container is heated so as to crosslink the composition in the B-stage state, to form reactive hot-melt silicone that is non-fluid at 25°C and has a melt viscosity of 5,000 Pa·s or lower at 120°C.

2. The reactive hot-melt silicone filling container according to Claim 1, wherein the crosslinkable silicone composition further comprises (D) a reaction inhibitor in an amount of 0.0001 to 5 parts by mass with regard to 100 parts by mass of the total of components (A) to (C).

3. The reactive hot-melt silicone filling container according to Claim 1 or 2, wherein the crosslinkable silicone composition further comprises (E) an organic peroxide in an amount of 0.01 to 10 parts by mass with regard to 100 parts by mass of the total of components (A) to (C).

4. The reactive hot-melt silicone filling container according to any one of Claims 1 to 3, wherein the container is a cartridge, a flexible container, a pail can, or a drum.

5. A method for manufacturing a reactive hot-melt silicone, comprising:
heating a crosslinkable silicone composition in a container, the composition comprising:
(A) an alkenyl group-bonded organopolysiloxane including at least a branched organopolysiloxane having an alkenyl group and a softening point of 50°C or higher;
(B) an organopolysiloxane having at least two silicon atom-bonded hydrogen atoms per molecule, in an amount such that the silicon atom bonded-hydrogen atoms in this component are 0.01 to 10 moles with regard to 1 mole of the alkenyl groups in component (A); and
(C) a hydrosilylation reaction catalyst in a catalyst amount,
so as to crosslink the composition in the B-stage state, to form reactive hot-melt silicone that is non-fluid at 25°C, and has a melt viscosity of 5,000 Pa·s or lower at 120°C.

6. The method for manufacturing reactive hot-melt silicone according to Claim 5, wherein the crosslinkable silicone composition further comprises (D) a reaction inhibitor in an amount of 0.0001 to 5 parts by mass with regard to 100 parts by mass of the total of components (A) to (C).

7. The method for manufacturing reactive hot-melt silicone according to Claim 5 or 6, wherein the crosslinkable silicone composition further comprises (E) an organic peroxide in an amount of 0.01 to 10 parts by mass with regard to 100 parts by mass of the total of components (A) to (C).

8. The method for manufacturing reactive hot-melt silicone according to any one of Claims 5 to 7, wherein the container is a cartridge, a flexible container, a pail can, or a drum.
